# EUROPEAN PATENT SPECIFICATION

(11) **EP 2 423 733 B1**
(45) Date of publication and mention of the grant of the patent: **16.09.2015**
(21) Application number: 11001388.5
(22) Date of filing: 19.02.2011
(51) Int. Cl.: G02F 1/1333, G02F 1/1335, F21V 8/00, G02F 1/1345

(54) **Display apparatus**
Anzeigevorrichtung
Appareil d'affichage

(30) Priority: 31.08.2010 KR 20100085128
(43) Date of publication of application: 29.02.2012
(73) Proprietor: Samsung Display Co., Ltd., Yongin-City, Gyeonggi-Do (KR)
(72) Inventor: Park, Jin-Ho, Suwon-si Gyeonggi-do (KR); Ha, Jae-Min, Yongin-si Gyeonggi-do (KR); Kang, Tae-Gil, Hwaseong-si Gyeonggi-do (KR); Park, Yong-Eun, Asan-si Chungcheongnam-do (KR); Ok, Jung-Soo, Asan-si Chungcheongnam-do (KR)
(74) Representative: Dr. Weitzel & Partner

(56) References cited:
- EP-A2- 2 192 438
- US-A- 5 946 062
- US-A1- 2005 018 102
- US-A1- 2005 286 008

## Description

### BACKGROUND OF THE INVENTION

### 1. Field of the Invention

A light providing assembly and a display apparatus are provided. More particularly, a light providing assembly having a stable and slim structure, and a display apparatus which also has a stable and slim structure are provided.

### 2. Description of the Related Art

Generally, a display apparatus includes a display panel displaying an image, a light providing assembly providing light to the display panel, and a driver providing driving and/or control signals to the display panel and the light providing assembly. The display panel may include a liquid crystal as a display element. The light providing assembly includes a light source module and a plurality of optical elements to effectively provide the light from the light source module to the display panel. The driver may include a printed circuit board and a plurality of chips mounted on the printed circuit board.

Recently, users are increasingly demanding display apparatuses that have a high display quality and also a slim and small body. Accordingly, light source modules in display apparatuses use light emitting diodes (LED), which have a high luminance while also having a low power consumption, as a light source. In addition, the thickness of the light providing assembly and the display panel can both be decreased, to decrease the overall thickness of the display apparatus. For example, instead of disposing the driver on a rear surface of the display panel, the driver is disposed in a spare space of a bottom chassis receiving the display panel and the light providing assembly, so that the driver may be disposed in substantially same plane as the display panel. As a result, the overall thickness of the display apparatus can be decreased.

However, the driver is electrically and physically connected to the display panel through a film which is very flexible, and therefore it is difficult to fix the driver in the spare space of the bottom chassis in a stable manner. A possible way to amount a flexible film is disclosed by US 2005/0018102 A1. In addition, a printed circuit board including a plurality of substrate layers is used to secure a predetermined space in which circuits may be formed. However, as the printed circuit board gets thicker, it becomes more difficult to dispose the driver on substantially the same plane as the display panel. Accordingly, when the display apparatus is received in a receiving container, a portion of the receiving container in which the printed circuit board is disposed may protrude toward an outside of the receiving container. Therefore, the display apparatus may have an unattractive appearance.

### SUMMARY OF THE INVENTION

A display apparatus having a slim structure capable of stably receiving a printed circuit board is provided.

A light providing assembly having a slim structure capable of stably receiving a printed circuit board is provided.

A display apparatus according to the invention is recited in appended independent claim 1. Other aspects of the invention are recited in the appended dependent claims.

According to the light providing assembly and the display apparatus, a substrate fixing portion of a receiving container may support a printed circuit board so that the printed circuit board may be stably received in the receiving container. The printed circuit board may be prevented from being bent or inclined so that rigidity of the display apparatus may be improved. Accordingly, the printed circuit board may be physically, electrically and stably received in the receiving container.

In addition, the substrate fixing portion is disposed in a spare space of the receiving container so that an increase in the size of the display apparatus may be minimized. The substrate fixing portion is disposed along a longitudinal side of a main receiving portion of the receiving container which has a relatively large area so that thickness of the printed circuit board may be decreased.

### BRIEF DESCRIPTION OF THE DRAWINGS

The above and other features and advantages will become more apparent by describing example embodiments with reference to the accompanying drawings, in which:
FIG. 1 is an exploded perspective view schematically illustrating a display apparatus according to an example embodiment;
FIG. 2 is a cross-sectional view taken along a line I-I' of FIG. 1;
FIG. 3 is a perspective view illustrating a receiving container of FIG. 1;
FIG. 4A is a plan view illustrating the display apparatus of FIG. 1 viewed in a direction A;
FIG. 4B is a rear view illustrating the display apparatus of FIG. 1;
FIG. 5 is a partially enlarged perspective view illustrating a combination between the display apparatus of FIG. 1 and an external apparatus;
FIG. 6A is a plan view illustrating a display apparatus according to another example embodiment;
FIG. 6B is a rear view illustrating the display apparatus of FIG. 6A;
FIG. 6C is a partially enlarged perspective view illustrating the display apparatus of FIG. 6A;
FIG. 7A is an enlarged perspective view illustrating a protruding portion of a receiving container according to still another example embodiment;
FIG. 7B is an enlarged perspective view illustrating a protruding portion of a receiving container according to still another example embodiment;
FIGS. 8A and 8B are plan views illustrating a receiving container and a mold frame according to still another example embodiment;
FIG. 9 is an exploded perspective view schematically illustrating a display apparatus according to still another example embodiment;
FIG. 10 is a cross-sectional view taken along a line II-II' of FIG. 9;
FIG. 11 is an exploded perspective view schematically illustrating a display apparatus according to still another example embodiment; and
FIG. 12 is a cross-sectional view taken along a line III-III' of FIG. 11.

### DETAILED DESCRIPTION OF THE INVENTION

Hereinafter, example embodiments will be explained with reference to the accompanying drawings.

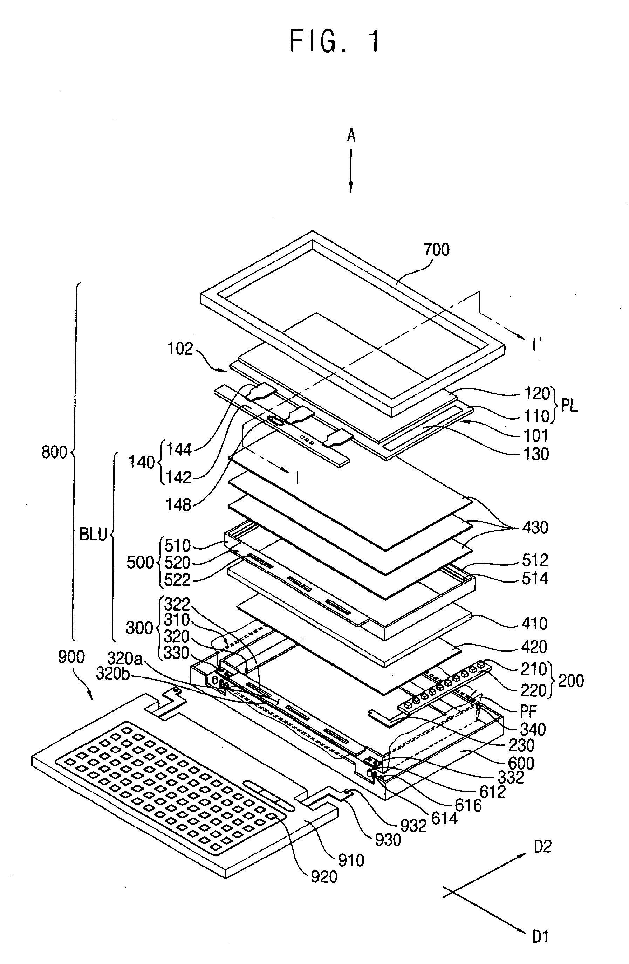

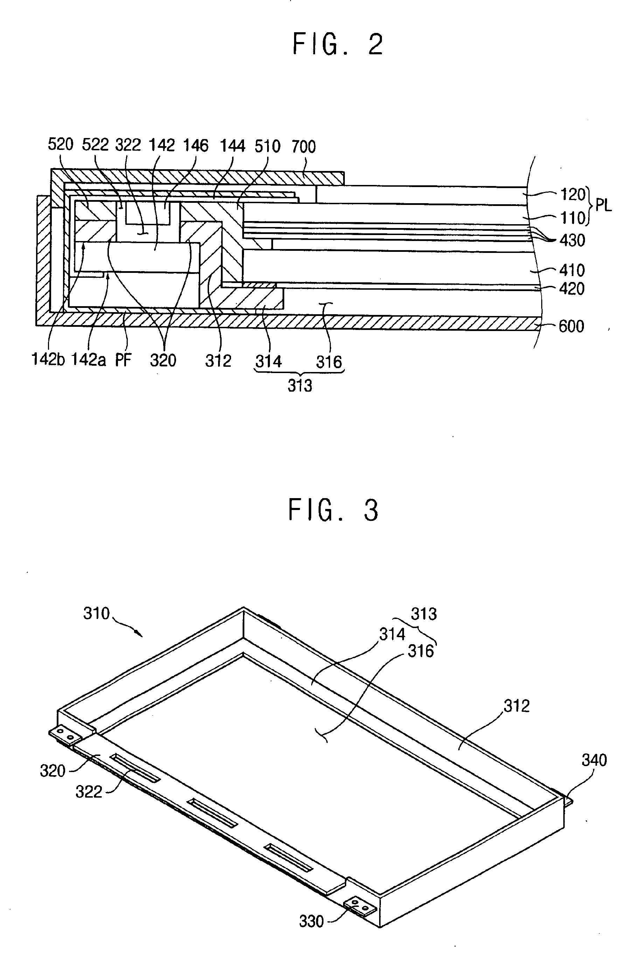

FIG. 1 is an exploded perspective view schematically illustrating a display apparatus according to an example embodiment. FIG. 2 is a cross-sectional view taken along a line I-I' of FIG. 1.

Referring to FIGS. 1 and 2, a display apparatus 800 includes a display panel PL, a light providing assembly BLU, a mold frame 500, a rear case 600 and a top case 700. A gate driving circuit 130 is mounted on the display panel PL, and the display panel PL is connected to a driver 140. The light providing assembly BLU includes a light source module 200, a receiving container 300, a light guide plate 410, a reflective plate 420 and optical sheets 430.

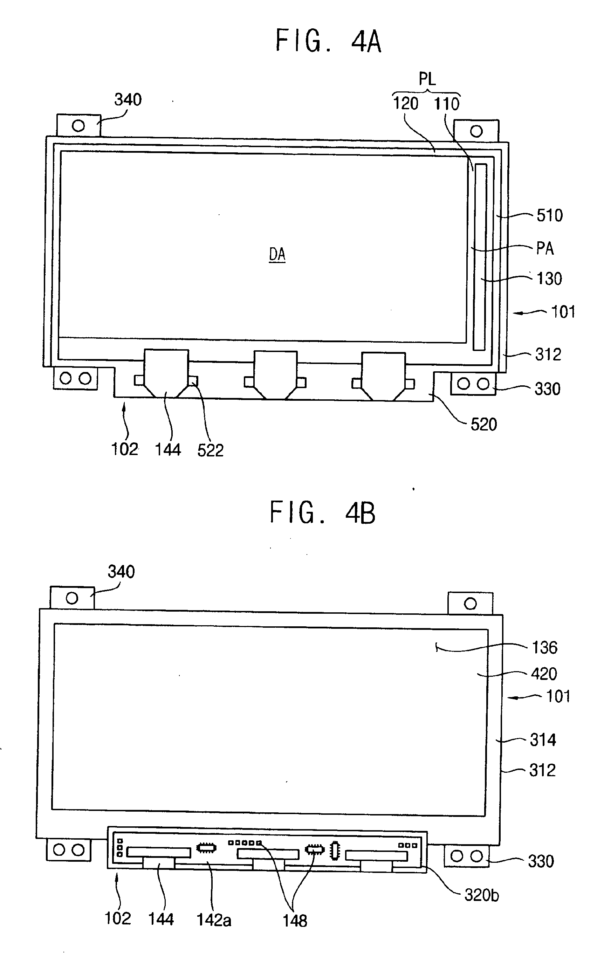

The display panel PL includes first and second substrates 110 and 120 facing each other. The display panel PL may use a liquid crystal disposed between the first substrate 110 and the second substrate 120 to adjust the transmittance of light through the display panel PL and thereby display an image. In the display panel PL, a display area DA (referring to FIG. 4A), which displays an image, is defined as an area of the first substrate 110 that is overlapped with the second substrate 120. A peripheral area PA (referring to FIG. 4A) of the display panel PL is defined as an area of the first substrate 110 that is not overlapped with the second substrate 120.

The gate driving circuit 130 is mounted in the peripheral area PA of the first substrate 110. The gate driving circuit 130 may be electrically connected to a gate line formed on the first substrate 110. In FIG. 1, though the gate driving circuit 130 is only disposed adjacent to a first side of the display area DA, the display apparatus 800 may further include the gate driving circuit 130 disposed adjacent to a second side of the display area DA that is opposite to the first side. When driving chips are disposed adjacent to both sides of the display area DA, the driving chips disposed adjacent to the first side may be connected to odd-numbered gate lines and the driving chips disposed adjacent to the second side may be connected to even-numbered gate lines to drive the display panel 800.

The driver 140 includes a printed circuit board 142, on which a plurality of circuit patterns are formed, and a flexible film 144, on which driving chips 146 are mounted. The driver 140 is electrically connected to the gate driving circuit 130 and the display area DA. A first end of the flexible film 144 is connected to the first substrate 110, and a second end opposite to the first end is connected to the printed circuit board 142. The flexible film 144 may be physically and electrically connected to the first substrate 110 and the printed circuit board 142 through, for example, an anisotropic conductive film (not shown). The driving chip 146 is mounted on a rear surface of the flexible film 144, and disposed in a direction opposite to a direction that the display panel PL displays an image.

The printed circuit board 142 extends along a first direction D1 of the display panel PL. The length of the printed circuit board 142 may be defined as a distance between a first end of the printed circuit board 142 and a second end of the printed circuit board 142 opposite to the first end in the first direction D1. The width of the printed circuit board 142 may be defined as a distance between a third end of the printed circuit board 142 and a fourth end of the printed circuit board 142 opposite to the third end in a second direction D2 different from the first direction D1. For example, the second direction D2 may be substantially perpendicular to the first direction D 1. The length of the printed circuit board 142 may be shorter than the length of the display panel PL in the first direction D1. The relatively shorter sides of the display panel PL (i.e., the sides along direction D2 in FIG. 1) are defined as short sides of the display panel PL, and an area adjacent to a short side is defined as a short side portion 101. In addition, a side of the display panel PL relatively longer than the short side (i.e., the sides along direction D1 of FIG. 1) is defined as a long side of the display panel PL, and an area adjacent to the long side is defined as a long side portion 102. In the present example embodiment, the length of the printed circuit board 142 is shorter than the length of the long side of the display panel PL extended in the first direction D1. The gate driving circuit 130 may be mounted on the short side portion 101 of the first substrate 110, and the driver 140 may be disposed adjacent to the long side portion 102.

Circuit patterns 148 are disposed on a first surface 142a of the printed circuit board 142, but circuit patterns 148 are not disposed on the second surface 142b opposite to the first surface 142a. Hereinafter, a circuit surface is defined as the first surface 142a on which the circuit patterns 148 are disposed, and a non-circuit surface is defined as the second surface 142b on which circuit patterns are not disposed. The light source module 200 is disposed along the short side portion 101 of the display panel PL, and the printed circuit board 142 is disposed along the long side portion 102 of the display panel PL. Because the printed circuit board 142 can be disposed along the long side portion 102, instead of the short side portion 101, the length of the printed circuit board 142 can be increased. As a result, there may be enough area on the printed circuit board 142 for all of the circuit patterns 148 required for driving the display panel PL to be disposed only on the circuit surface 142a, and not the non-circuit surface 142b. Therefore, because the surface area of the printed circuit board 142 may be maximized, the number of substrate layers required for the printed circuit board 142 can be minimized, which allows the thickness of the printed circuit board 142 to be decreased.

The light source module 200 includes a plurality of light sources 210 emitting light and a circuit substrate 220 electrically connected to the light sources 210 and transmitting a light source driving signal to the light sources 210. The circuit substrate 220 is connected to the printed circuit board 142 through a connecting line 230. For example, the connecting line 230 may be disposed on a flexible printed circuit board. The light source driving signal received from outside is provided to the circuit substrate 220 through the connecting line 230, and is provided to the light sources 210 through the circuit substrate 220. The light sources 210 may include, for example a light emitting diode (LED), and the number of the light sources 210 may be, for example, about 27.

The receiving container 300 receives the light source module 200, the light guide plate 410, the reflective plate 420, the optical sheets 430 and the mold frame 500. The receiving container 300 may include a metal. For example, the receiving container 300 may include aluminum, galvalume, etc. The receiving container 300 includes a main receiving portion 310 that substantially receives the elements such as the light guide plate 410, the reflective plate 420, the optical sheets 430 and the mold frame 500, and a substrate fixing portion 320 that is connected to the main receiving portion 310. The substrate fixing portion 320 may include a first hole 322. The receiving container 300 will be explained in more detail below with reference to FIG. 3.

The light guide plate 410 is disposed adjacent to the light source module 200 along a direction in which the light source module 200 emits the light. Light emitted from light source module 200 is received by the light guide plate 410 through an incident surface of the light guide plate 410, travels through the inside of the light guide plate 410, and exits to the optical sheets 430 through an exiting surface of the light guide plate 410. The reflective surface 420 faces a lower surface of the light guide plate 410 that is opposite to the exiting surface of the light guide plate 410. The optical sheets 430 face the exiting surface of light guide plate 410.

The mold frame 500 includes a main body portion 510 and a cover portion 520. The mold frame 500 may include, for example, a plastic material. The main body portion 510 substantially includes four sidewalls 512, and supporting protrusions 514 that protrude from the sidewalls 512 towards the opposite sidewalls 512 are respectively formed at the four sidewalls 512. The light source module 200, the light guide plate 410 and the reflective plate 420 may be disposed in an under section of the main body portion 510, and may be fixed at the receiving container 300 by the supporting protrusions 514 of the mold frame 500. The optical sheets 430 and the display panel PL may be disposed in an upper section the main body portion 510, and may be supported by the supporting protrusions 514 of the mold frame 500. The cover portion 520 is disposed on a first surface 320a of the substrate fixing portion 320, and substantially covers the first surface 320a of the substrate fixing portion 320. The cover portion 520 is typically disposed between the substrate fixing portion 320 and the flexible film 144. Accordingly, the cover portion 520 substantially makes contact with a lower surface of the flexible film 144. The cover portion 520 may further include a second hole 522 formed in an area corresponding to an area in which the first hole 322 of substrate fixing potion 320 is formed. The cover portion 520 typically has substantially the same planar shape as the substrate fixing portion 320.

The edges of the display panel PL and the light providing assembly BLU may be covered by a sealing film PF. The sealing film PF may be a black film blocking light. The sealing film PF may include an attachment portion to be attached at an edge of the display panel PL and the light providing assembly BLU. For example, the attachment portion of sealing film PF may be disposed in a position corresponding to the position of the cover portion 520 that is not covered by flexible film 144, that is, between flexible films 144 (see FIG 4A). At the long side portion 102, the sealing film may be bent along a direction that the flexible film is bent so that the sealing film PF may be attached to the cover portion 520. In this manner, the sealing film PF along the long side portion 102 covers the edges of the display panel PL and the light providing assembly BLU adjacent to the display panel PL. The sealing film PF does not overlapped with the display area DA.

The rear case 600 is disposed under the receiving container 300, and entirely receives the display panel PL and the light providing assembly BLU including the receiving container 300. A first combining hole protrusion 612, a combining protrusion 614 and a second combining hole protrusion 616 are formed on a bottom plate of the rear case 600. The first and second combining hole protrusions 612 and 616 protrude from the bottom plate of the rear case 600, and include holes, which may be, for example, threaded, for combining with screws. The rear case 600 may be combined with the top case 700 to entirely cover the display panel PL and the light providing assembly BLU. The top case 700 includes an opening exposing the display area DA. The rear case 600 and the top case 700 of the present example embodiment may improve the appearance and stability of the display apparatus 800. For example, when the display panel PL and the light providing assembly BLU are covered by the sealing film PF, the display panel PL and the light providing assembly BLU covered by the sealing film PF are disposed inside of the rear case 600 and the top case 700. Thus, the sealing film PF is not observed from outside of the display apparatus 800, so that the appearance of the display apparatus 800 may be prevented from being declined.

Hereinafter, the receiving container 300, the mold frame 500 and how the receiving container 300, the printed circuit board 142 and the flexible film 144 are combined is explained in more detail in reference to FIGS 3, 4A and 4B.

FIG. 3 is a perspective view illustrating a receiving container of FIG. 1.

Referring to FIGS. 1 to 3, the main receiving portion 310 of receiving container 300 includes four sidewalls 312 and a bottom plate 313 connected to the sidewalls 312. The sidewalls 312 are connected to each other so that a receiving space of the receiving container 300 is defined.

The bottom plate 313 includes supporting protrusions 314 respectively protruded from the sidewalls 312 to the receiving space 300. The supporting protrusions 314 may define a bottom opening 316 of the bottom plate 313. The supporting protrusions 314 respectively extend along the direction in which the sidewalls 312 extend, and respectively protrude in a direction substantially perpendicular to the direction in which the sidewalls 312 extend. The supporting protrusions 314 are respectively connected to lower portions of the sidewalls 312.

The supporting protrusions 314 substantially support the reflective plate 420, the light guide plate 410, the optical sheets 430 and the mold frame 500 received in the receiving container 300. The supporting protrusions 314 are used so that an area of the bottom plate 313 may be minimized (and the bottom opening 316 maximized). Accordingly, weight of the receiving container 300 may be minimized. Edges of the reflective plate 420 are disposed on the bottom plate 313 so that the reflective plate 420 is fixed to the bottom plate 313. As the reflective plate 420 is combined with the main receiving portion 310, the receiving space of the receiving container 300 may be substantially secured. The space defined by the main receiving portion 310 combined with the reflective plate 420 may, for example, received the light source module 200, the light guide plate 410, the optical sheets 430 and the mold frame 500.

The substrate fixing portion 320 is connected to the sidewall 312 at the long side portion 102 among the sidewalls 312. The substrate fixing portion 320 extends in the first direction D 1 along a side of the main receiving portion 310. The substrate fixing portion 320 protrudes from the main receiving portion 310 in the second direction D2. The substrate fixing portion 320 is disposed at a position on sidewall 312 that is above the position of the support protrusion 314, closer to the display panel PL, of the main receiving portion 310. The substrate fixing portion 320 and the sidewalls 312 connected to the substrate fixing portion 320 define a predetermined space, and the printed circuit board 142 is disposed in the predetermined space.

FIG. 4A is a plan view illustrating the display apparatus of FIG. 1 viewed in a direction A (indicated on FIG. 1). FIG. 4B is a rear view illustrating the display apparatus of FIG. 1.

In FIGS. 4A and 4B, the top case 700 and the rear case 600 are omitted so that the structures of the receiving container 300 and the mold frame 500 may be more clearly illustrated.

Referring to FIGS. 4A and 4B, the substrate fixing portion 320 includes the first and second surfaces 320a and 320b. The second surface 320b opposite to the first surface 320a directly makes contact with the printed circuit board 142.

The cover portion 520 of the mold frame 500 is disposed on the first surface 320a (not seen in FIGS. 4A and 4B) of the substrate fixing portion 320. The cover portion 520 directly makes contact with the flexible film 144 when viewed in the direction A of FIG. 1. The flexible film 144 extends from the first substrate 110 in the second direction D2 via the cover portion 520 (which is over the first surface 320a of substrate fixing portion 320). The flexible film 144 is bent (FIG. 2) around the edge of cover portion 520, passing the edge of the substrate fixing portion 320 from the first surface 320a to the second surface 320b. The flexible film 144 covers the cover portion 520 and is bent around the edges of cover portion 520 and substrate fixing portion 320 so that the printed circuit board 142 may face the second surface 320b. The non-circuit surface 142b of the printed circuit board 142 may thus directly make contact with the second surface 320b. An entire shape of the substrate fixing portion 320 may be substantially the same as a shape of the printed circuit board 142. The substrate fixing portion 320 supports the printed circuit board 142 so that the printed circuit board 142 is not bent by the external force, and is stably received in the receiving container 300. The driving chip 146 (FIG. 2) is mounted on the lower surface of the flexible film 144 so that the driving chip 146 faces an opposite side of the substrate fixing portion 320 from the position of the printed circuit board 142, that is, the driving chip 146 faces the first surface 320a side of the substrate fixing portion 320.

In addition, the mold frame 500 and the display panel PL (FIG. 2) are disposed in the receiving space of the receiving container 300 so that inner surfaces of the sidewalls 312 of the receiving container 300 cover outer surfaces of the main body portion 510 of the mold frame 500. An upper portion of the sidewall 312 which is connected to the substrate fixing portion 320 among the sidewalls 312 of the receiving container 300 may be covered by the cover portion 520 of the mold frame 500.

As shown in FIG. 4B, the receiving container 300 includes the bottom opening 316 defined by the supporting protrusions 314 so that the reflective plate 420 is partially exposed through the bottom opening 316 in a rear surface of the receiving container 300.

The substrate fixing portion 320 and the printed circuit board 142 may include holes (not shown) corresponding to each other. The substrate fixing portion 320 and the printed circuit board 142 may be combined using a screw that passes through the corresponding holes. Alternatively, the substrate fixing portion 320 and the printed circuit board 142 may be combined using a double sided attaching tape disposed between the second surface 320b of the substrate fixing portion 320 and the non-circuit surface 142b of the printed circuit board 142.

The substrate fixing portion 320 may further include the first hole 322 (FIGS. 2 and 3)that passes through the substrate fixing portion 320, and cover portion 520 may include second hole 522 that passes through the cover portion 520. The driving chip 146 is disposed in the second hole 522 and a portion of first hole 322. As the flexible film 144 is bent around the edge of cover portion 520 and substrate fixing portion 320, the driving chip 146 mounted on the lower surface of the flexible film 144 faces the first surface 320a side of the substrate fixing portion 320. The driving chip 146 has predetermined thickness from which it protrudes from the flexible film 144. Thus, if only the second hole 522 is formed in cover portion 520, and first hole 322 is not formed on substrate fixing portion 320, the driving chip 146 is disposed on the first surface 320a, and , the flexible film 144 may, depending on the depth of first hole 522, be protruded from the first surface 320a. According to the present example embodiment, the first hole 322 is formed through the substrate fixing portion 320 and driving chip 146 is disposed in the first hole 322, so that the flexible film 144 may be tightly stuck to the cover portion 520.

Though the first hole 322 passing through the cover portion 520 and substrate fixing portion 320 is formed to receive the driving chip 146 in the present example embodiment of FIGS. 1 to 3. Instead of a first hole 322 that passes through the substrate fixing portion 320, a recess in substrate fixing portion 320 (not shown) to receive the driving chip 146 may be alternatively formed. The recess has depth that is large enough so that the combination of the depth of the second hole 522 and such a recess in substrate fixing portion 320 is greater than the thickness of the driving chip 146.

The second hole 522 of the cover portion 520 is disposed in an area in which the first hole 322 is disposed. The second hole 522 may have a shape substantially same as the first hole 322. The cover portion 520 covers the first surface 320a of the substrate fixing portion 320 so that the driving chip 146 is disposed in the first hole 322 through the second hole 522, or the driving chip 146 is disposed in the second hole 522 and the first hole 322. For example, entire depth of the first and second holes 322 and 522 may be greater than the thickness of the driving chip 146.

The receiving container 300 may further include a first connection portion 330. The first connecting portion 330 is formed on the sidewall 312 which is connected to the substrate fixing portion 320. The first connecting portion 330 protrudes from the substrate fixing portion 320 in the second direction D2, and includes two holes 332. The receiving container 300 may be connected to an external apparatus 900 and the rear case 600 through the first connecting portion 330. The first connecting portion 330 may be disposed adjacent to both ends of the substrate fixing portion 320. The receiving container 300 may further include a second connection portion 340, and the second connection portion 340 is formed on a sidewall opposite to the sidewall on which the first connecting portion 330 is formed. The second connecting portion 340 may connect the receiving container 300 to the rear case 600. For example, the receiving container 300 may be fixed to the rear case 600 through the first and second connecting portions 330 and 340. Hereinafter, the combination between the receiving container 300, the rear case 600 and the external apparatus 900 may be explained.

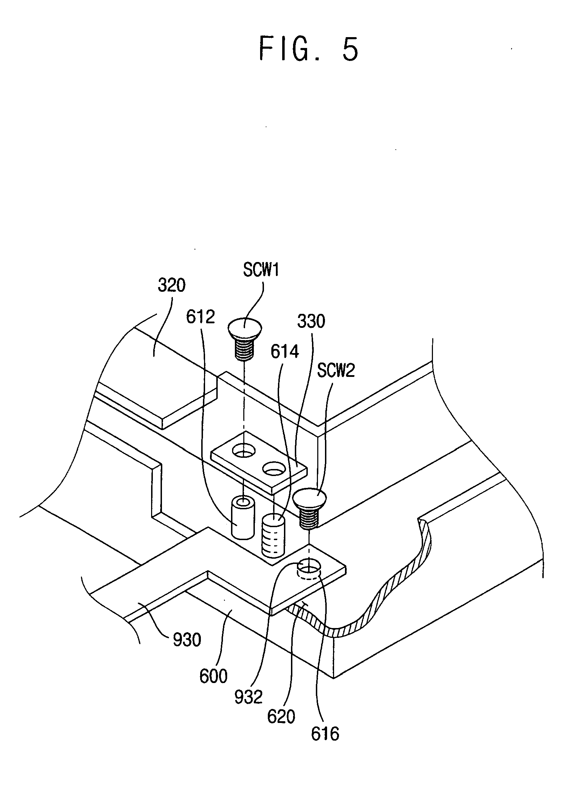

FIG. 5 is a partially enlarged perspective view illustrating a combination between the display apparatus of FIG. 1 and an external apparatus.

Referring to FIGS. 1 and 5, a hole 332 of the first connecting portion 330 is disposed in a position that corresponds to the position of the first combining hole protrusion 612. A first screw SCW1 passes through the hole 332, and is inserted into a first combining hole of the first combining hole protrusion 612. Another hole 332 of the first connecting portion 330 is disposed corresponding to the combining protrusion 614. The combining protrusion 614 is inserted into the hole 332. Accordingly, the receiving container 300 may be combined with the rear case 600. Although not shown in figures, the second connecting portion 340 may be combined with the combining protrusion formed on the bottom plate 613 of the rear case 600. Four corner portions of the receiving container 300 may be fixed to the rear case 600 by two first connecting portions 330 formed on the sidewalls 312 of the receiving container 300 and two second connecting portions 340 formed on the opposite sidewalls 312 of the receiving container 300.

The rear case 600 combined with the receiving container 300 may be combined with the external apparatus 900 by the second combining hole protrusion 616. As shown in FIG. 1, the external apparatus 900 may include an input part by which a user inputs information to the information processing apparatus. For example, the external apparatus 900 includes a keyboard 910. A plurality of keys 920 may be disposed on the keyboard 910. The keyboard 910 is connected to a hinge part 930. The hinge part 930 may move freely in a direction substantially perpendicular to a plane defined by the first and second directions D1 and D2. A receiving recess 620 to receive the hinge part 930 may be formed at a sidewall of the rear case 600. A hole 932 is formed at an end portion of the hinge part 930. The hole 932 corresponds to the second combining hole protrusion 616 of the rear case 600, and is connected to a second combining hole by a second screw SCW2.

In FIG. 1, a laptop computer combined with the external apparatus 900 having the input part is explained as the display apparatus 800, but alternatively, the display apparatus 800 may be used for an apparatus not combined with the external apparatus 900 such as a monitor, a television and so on.

According to the present example embodiment, the substrate fixing portion 320 of the receiving container 300 supports the printed circuit board 142 so that the printed circuit board 142 may be stably combined with the receiving container 300. The substrate fixing portion 320 may prevent the printed circuit board 142 from being bent or inclined so that rigidity of the display apparatus 800 may be improved. Accordingly, the printed circuit board 142 may be physically, electrically and stably received in the receiving container 300. In addition, the substrate fixing portion 320 is disposed in the long side portion 102, and the light source module 200 is disposed in the short side portion 101, so that the area for the substrate fixing portion 320 may be sufficiently secured without increasing a size of the display apparatus 800, and thickness of the printed circuit board 142 may be decreased.

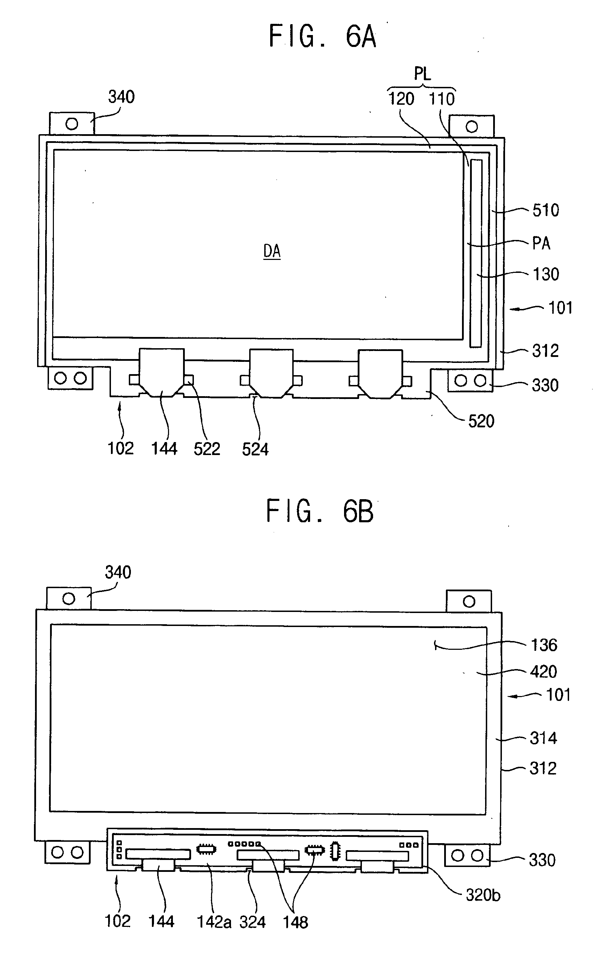

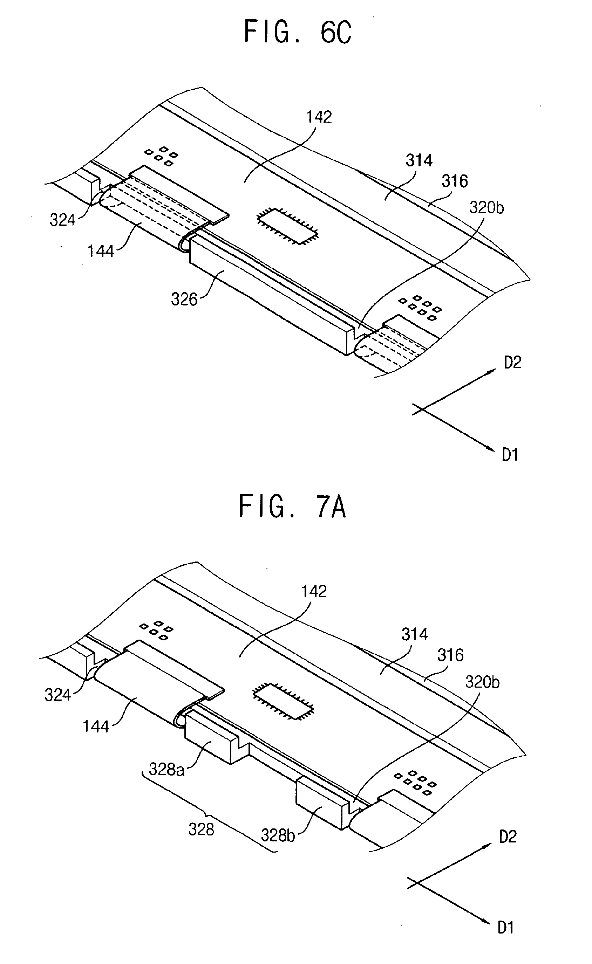

FIG. 6A is a plan view illustrating a display apparatus according to another example embodiment. FIG. 6B is a rear view illustrating the display apparatus of FIG. 6A. FIG. 6C is a partially enlarged perspective view illustrating the display apparatus of FIG. 6A.

The display apparatus according to the present example embodiment is substantially the same as the display apparatus according to the previous example embodiment explained referring to FIGS. 1 and 2 except that the receiving container further includes a guide recess and a protrusion. Thus, any repetitive explanation will be omitted.

Referring to FIGS. 1, 6A, 6B and 6C, the receiving container 300 according to the present example embodiment includes the guide recess 324 (FIG. 6B) formed at the substrate fixing portion 320. The mold frame 500 according to the present example embodiment includes a corresponding recess 524 (FIG. 6A) formed at the cover portion 520 corresponding to the guide recess 324.

Each of the guide recess 324 and the corresponding recess 524 is formed in a direction from an outside of the display apparatus 800 to the main receiving portion 310 of the receiving container 300 to guide the flexible film 144 to be bent. The corresponding recess 524 may have a substantially same shape as the guide recess 324. Each of the guide recess 324 and the corresponding recess 524 may have width in the first direction D1 greater than width of the flexible film 144 in the first direction D1. In addition, each of the guide recess 324 and the corresponding recess 524 may have depth in the second direction D2 greater than thickness of the flexible film 144. The guide recess 324 and the corresponding recess 524 help the flexible film 144 to be easily bent so that a movement of the flexible film 144 in the first direction D 1 may be minimized.

In a structure in which the flexible film connecting the display panels and the printed circuit board directly covers the printed circuit board, (and which does not employ a substrate fixing portion 320), a recess such as the guide recess 324 would be formed at the printed circuit board 142 and as a result the available space for the circuit patterns 148 on the printed circuit board may be decreased. However, in the present example embodiment, the guide recess 324 and the corresponding recess 524 are formed at the receiving container 300 and the mold frame 500, and not on the printed circuit board 142, so that the space for the circuit patterns 148 may be maximized.

The substrate fixing portion 320 may further include a protrusion 326 (FIG. 6C). The protrusion 326 is formed on a first end portion of the substrate fixing portion 320 opposite to a second end portion of the substrate fixing portion 320 at which the substrate fixing portion 320 is connected to the main receiving portion 310. The protrusion 326 protrudes from the first surface 320a to the second surface 320b opposite to the first surface 320a. For example, the protrusion 326 may form an "L" shape with the first end portion of the substrate fixing portion 320. The protrusion 326 may prevent the printed circuit board 142 from moving in the second direction D2. For example, because the protrusion 326 is formed, the printed circuit board 142 may be stably received in a space defined by the second surface 320b of the substrate fixing portion 320, the protrusion 326 and the sidewall 312 of the main receiving portion 310. The protrusion 326 may be disposed between the guide recesses 324 adjacent to each other. For example, the guide recess 324 may be disposed between the protrusions 326 adjacent to each other.

According to the present example embodiment, the substrate fixing portion 320 is formed so that the printed circuit board 142 may be stably fixed. The guide recess 324 is additionally formed at the substrate fixing portion 320 so that the printed circuit board 142 may be easily assembled, and the movement of the flexible film 144 may be minimized. In addition, the protrusion 326 is formed so that the printed circuit board 142 may be more stably fixed at the substrate fixing portion 320.

FIG. 7A is an enlarged perspective view illustrating a protruding portion of a receiving container according to still another example embodiment.

The display apparatus according to the present example embodiment is substantially the same as the display apparatus according to the previous example embodiment explained referring to FIGS. 6A, 6B and 6C except for a shape of the protrusion. Thus, any repetitive explanation will be omitted.

Referring to FIG. 7A, the substrate fixing portion 320 of the receiving container 300 according to the present example embodiment includes a protrusion 328. The protrusion 328 includes at least two sub protrusions 328a and 328b spaced apart from each other.

Each of the sub protrusions 328a and 328b protrudes from the first surface 320a to the second surface 320b opposite to the first surface 320a The protrusion 328 includes the sub protrusions 328a and 328b.. The sub protrusions 328a and 328b are spaced apart from each other so that the sub protrusions allow a contacting area between the substrate fixing portion 320 and the rear case 600 to be decreased and an external force to the substrate fixing portion 320 may be uniformly distributed.

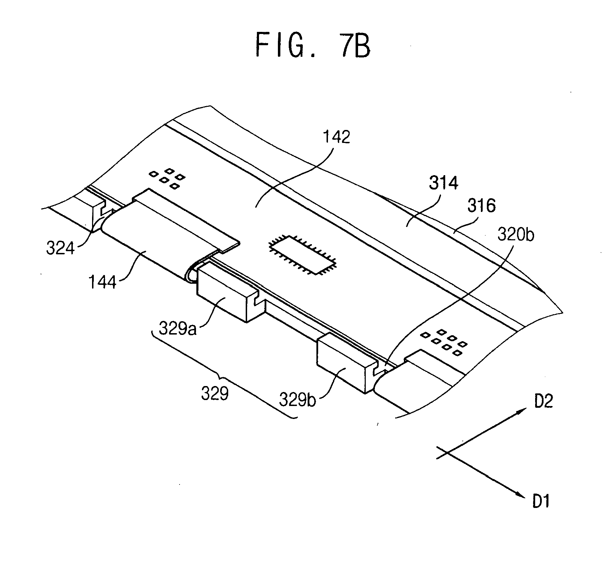

FIG. 7B is an enlarged perspective view illustrating a protruding portion of a receiving container according to still another example embodiment of the present invention.

The display apparatus according to the present example embodiment is substantially the same as the display apparatus according to the previous example embodiment explained referring to FIG. 7A except for a shape of the protrusion. Thus, any repetitive explanation will be omitted.

Referring to FIG. 7B, the substrate fixing portion 320 of the receiving container 300 according to the present example embodiment includes a protrusion 329. The protrusion 329 includes at least two sub protrusions 329a and 329b. The sub protrusions 329a and 329b are spaced apart from each other.

Each of the sub protrusions 329a and 329b protrudes from the first surface 320a to the second surface 320b opposite to the first surface 320a, and end portions of the sub protrusions 329a and 329b extend in a direction substantially parallel to the second surface 320b in predetermined length. For example, each of the sub protrusions 329a and 329b has an "L" shape, and each of the sub protrusions 329a and 329b may form a "U" shape with the end portion of the substrate fixing portion 320.

According to the present example embodiment, the shape of the sub protrusions 329a and 329b are changed compared to that in the previous example embodiment in FIG. 7A, so that the printed circuit board 142 may be relatively solidly and stably fixed to the second substrate 320b of the substrate fixing portion 320.

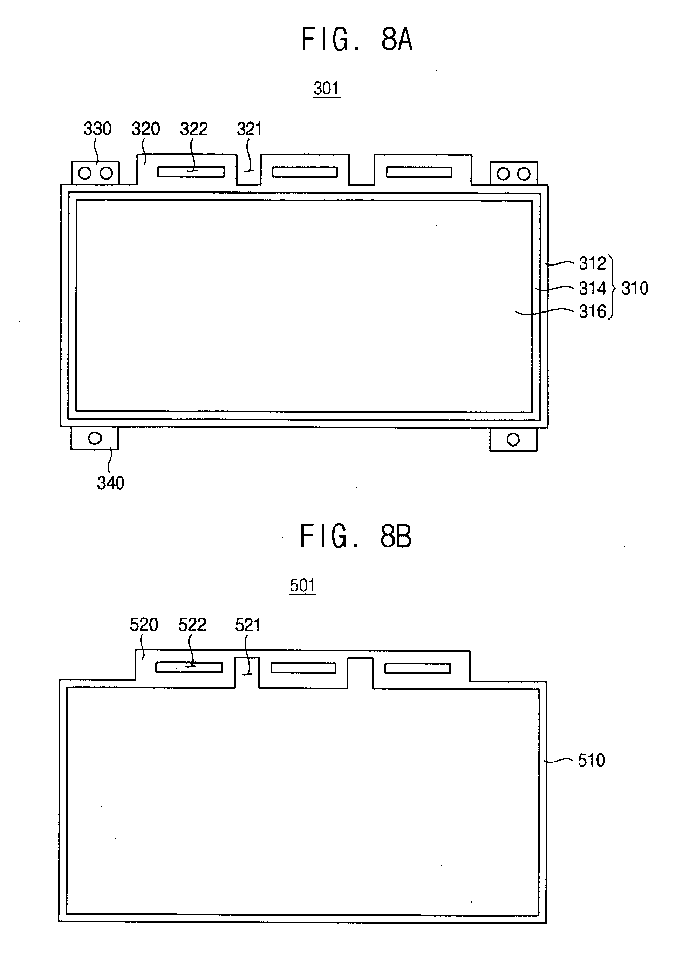

FIGS. 8A and 8B are plan views illustrating a receiving container and a mold frame according to still another example embodiment.

The receiving container and the mold frame according to the present example embodiment is substantially the same as the receiving container and the mold frame according to the previous example embodiment explained referring to FIGS. 1 and 2 except that the receiving container and the mold frame further include additional openings. Thus, any repetitive explanation will be omitted.

Referring to FIGS. 1 and 8A, the receiving container 301 includes the main receiving portion 310 and the substrate fixing portion 320 connected to the main receiving portion 310. The printed circuit board 142 connected to the display panel PL through the flexible film 144 may be disposed in the substrate fixing portion 320. The receiving container 301 may further include the first connecting portion 330 and the second connecting portion 340. The first and second connecting portions 330 and 340 connect the external apparatus 900 to the rear case 600. The first hole 322 receiving the driving chip 146 mounted on the flexible film 144 may be formed on the substrate fixing portion 320.

An opening 321 is formed at the substrate fixing portion 320 between the first holes 322 adjacent to each other. The opening 321 may be formed at the substrate fixing portion 320 in an area which is not covered by the flexible film 144. Though the opening 321 is formed, the substrate fixing portion 320 may support the printed circuit board 142. Thus, weight of the receiving container 301 may be minimized.

Referring to FIGS. 1 and 8B, the mold frame 501 according to the present example embodiment includes the main body portion 510 and the cover portion 520 connected to the main body portion 510. The second hole 522 may be formed through the cover portion 520. The driving chip 146 is received by the second hole 522, and the second hole 522 corresponds to the first hole 322.

An opening 521 may be formed at the cover portion 520 between the second holes 522 adjacent to each other. The opening 521 may be formed at the cover portion 520 in an area which is not covered by the flexible film 144. Though the opening 521 is formed, portions of cover portion 520 in which there is no opening 521 continue cover the substrate fixing portion 320. Thus, weight of the mold frame 501 may be minimized.

Although not shown in figures, the receiving container 301 may further include the guide recess 324 of FIGS. 6A and 6B. In addition, the mold frame 501 may further include the corresponding recess 524 of FIGS. 6A and 6B.

In addition, the shape of the opening 321 of the receiving container 301 illustrated in FIG. 8A may be used for the opening 521 of the mold frame 501, and a shape of the opening 521 of the mold frame 501 illustrated in FIG. 8B may be used for the opening 321 of the receiving container 301.

According to the present example embodiment, the substrate fixing portion 320 of the receiving container 301 is formed so that the printed circuit board 142 may be stably fixed. In addition, the openings are respectively formed at the substrate fixing portion 320 and the cover portion 520 so that the weight of the receiving container 301 and the mold frame 501 may be decreased. Accordingly, weight of the display apparatus including the receiving container 301 and the mold frame 501 may be decreased.

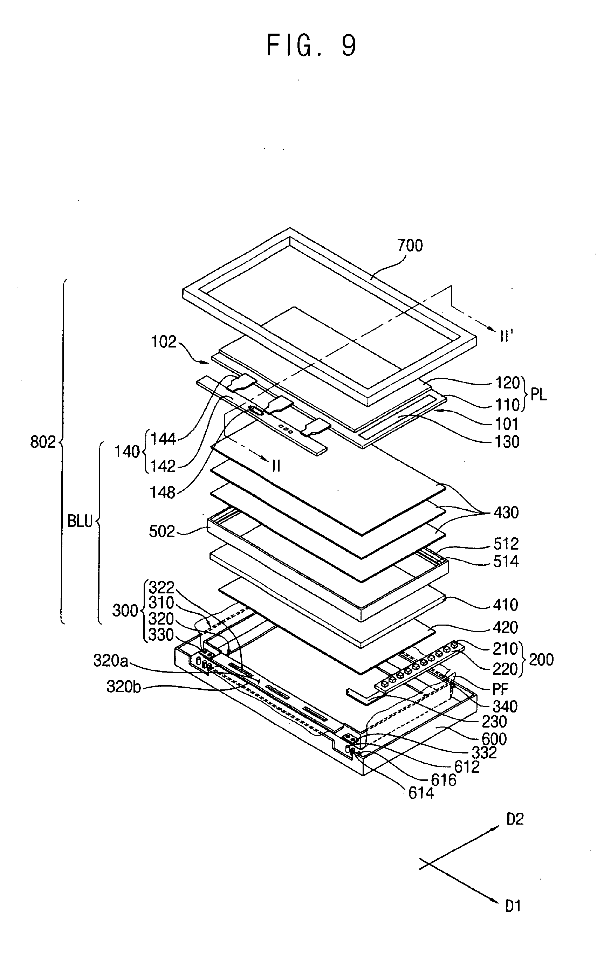

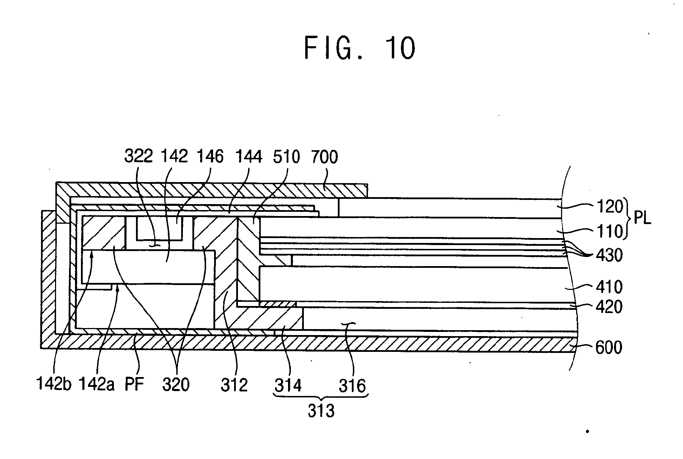

FIG. 9 is an exploded perspective view schematically illustrating a display apparatus according to still another example embodiment of the present invention. FIG. 10 is a cross-sectional view taken along a line II-II' of FIG. 9.

The display apparatus according to the present example embodiment is substantially the same as the display apparatus according to the previous example embodiment explained referring to FIGS. 1 and 2 except for structures of a receiving container and a mold frame and a combination between the receiving container and the mold frame. Thus, any repetitive explanation will be omitted.

Referring to FIGS. 9 and 10, the receiving container 300 of the display apparatus 802 according to the present example embodiment includes the main receiving portion 310 and the substrate fixing portion 320. The receiving container 300 according to the present example embodiment is substantially the same as the receiving container 300 according to the previous example embodiment explained referring to FIGS. 1 and 2 except for a position of the substrate fixing portion 320. The substrate fixing portion 320 of the present example embodiment is disposed relatively higher than the substrate fixing portion 320 shown in FIGS. 1 and 2 with respect to the supporting protrusions 314 of the main receiving portion 310.

The mold frame 502 is disposed inside of the receiving container 300. The mold frame 502 according to the present example embodiment is substantially the same as the mold frame 500 according to the previous example embodiment explained referring to FIGS. 1 and 2 except that the mold frame 502 only includes the main body portion 510, and does not contain a cover portion 520. Thus, the mold frame 502 is disposed over the light source module 200, the light guide plate 410 and the reflective plate 420 so that the mold frame 502 may fix the light source module 200, the light guide plate 410 and the reflective plate 420 to the receiving container 300. The mold frame 502 may support the optical sheets 430 and the display panel PL.

Because the mold frame 502 does not include the cover portion 520 shown in FIGS. 1 and 2, the substrate fixing portion 320 has a height greater than a height of the substrate fixing portion 320 of FIGS. 1 and 2. Accordingly, the flexible film 144 extended outward from the display panel PL may be evenly disposed over an upper surface of the substrate fixing portion 320.

According to the present example embodiment, the structure of the receiving container 300 is changed to include the main receiving portion 310 and the substrate fixing portion without changing a structure of the conventional mold frame disposed inside of the receiving container 300, so that the printed circuit board 142 connected to the flexible film 144 may be stably received in the substrate fixing portion 320. The flexible film 144 may be evenly disposed on the upper surface of the substrate fixing portion 320.

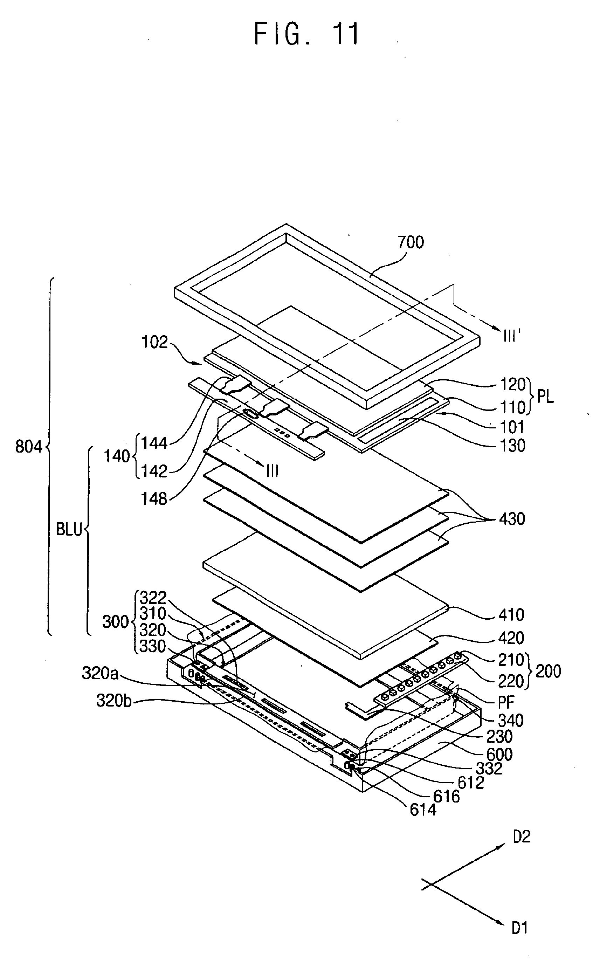

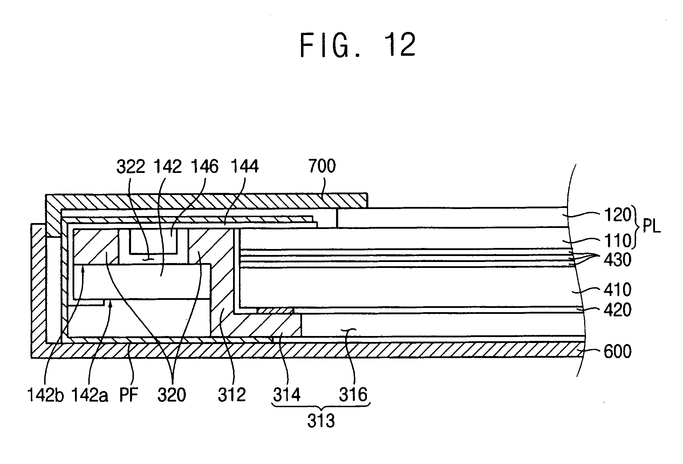

FIG. 11 is an exploded perspective view schematically illustrating a display apparatus according to still another example embodiment of the present invention. FIG. 12 is a cross-sectional view taken along a line III-III' of FIG. 11.

The display apparatus 804 according to the present example embodiment is substantially the same as the display apparatus 800 according to the previous example embodiment explained referring to FIGS. 1 and 2 except that the mold frame 500 is omitted. Thus, any repetitive explanation will be omitted.

Referring to FIGS. 11 and 12, the display apparatus 804 according to the present example embodiment includes the receiving container 300. The reflective plate 420, the light guide plate 410, the light source module 200, the optical sheets 430 and the display panel PL may be received in a receiving space of the receiving container 300. The optical sheets 430 may be disposed directly on the light guide plate 410. Comparing to the display apparatus 800 according to the previous example embodiment of FIGS. 1 and 2, the mold frame 500 shown in FIG. 1 is omitted so that a space between the optical sheets 430 and the light guide plate 410 is omitted. Thus, thickness of the display apparatus 804 may be decreased by thickness of the mold frame 500.

Comparing to the display apparatus 800 according to the previous example embodiment of FIGS. 1 and 2, an area of the display apparatus 804 may be increased by thickness of the sidewalls of the mold frame 500 and weight of the display apparatus 804 may be decreased by weight of the mold frame 500.

According to the present example embodiment, the mold frame 500 shown in FIGS. 1 and 2 is omitted and the receiving container 300 includes the main receiving portion 310 and the substrate fixing portion 320, so that the printed circuit board 142 connected to the flexible film 144 may be stably received in the substrate fixing portion 320. The flexible film 144 that extends outward from the display panel PL may be evenly disposed over the upper surface of the substrate fixing portion 320. The flexible film 144 is bent from the first surface 320a of the substrate fixing portion 320 to the second surface 320b. The second surface 320b opposite to the first surface 320a directly makes contact with the printed circuit board 142.

According to the present invention as explained above, the substrate fixing portion 320 of the receiving container supports the printed circuit board 142 so that the printed circuit board 142 may be prevented from being bent or inclined. Accordingly, a rigidity of the display apparatus may be improved. The display apparatus including the receiving container may be used for a display part of a laptop computer, a monitor, a television and so on.

The foregoing is illustrative and is not to be construed as limiting thereof. Although a few example embodiments of the present invention have been described, those skilled in the art will readily appreciate that many modifications are possible in the example embodiments without materially departing from the novel teachings and advantages describe herein. In the claims, means-plus-function clauses are intended to cover the structures described herein as performing the recited function and not only structural equivalents but also equivalent structures. Therefore, it is to be understood that modifications to the disclosed example embodiments, as well as other example embodiments, are intended to be included within the scope of the appended claims and the foregoing description.

## Claims

1. A display apparatus comprising:
a display panel (PL) configured to display an image;
a light source module (200) configured to provide light to the display panel (PL);
a printed circuit board (142) electrically connected to the light source module (200), and electrically connected to the display panel (PL) through a flexible film (144); and
a receiving container (300) that comprises a main receiving portion (310) and a substrate fixing portion (320), the main receiving portion (310) includes four sidewalls (312) and a bottom plate (313) connected to the sidewalls (312) to define a receiving space receiving the light source module (200) and the display panel (PL), the substrate fixing portion (320) is integrally connected to the main receiving portion (310), extends along a sidewall of the main receiving portion (310) in a first direction (D1), protrudes outwards from the main receiving portion (310) in a second direction (D2) orthogonal to the first direction (D1), and supports the printed circuit board (142);
wherein the flexible film (144) extends outward from the display panel (PL) in said second direction (D2) over a first surface (320a) of the substrate fixing portion (320), and is bent from the first surface (320a) to a second surface (320b) of the substrate fixing portion (320) opposite to the first surface (320a); and
wherein the printed circuit board (142) makes contact with the second surface (320b) of the substrate fixing portion (320).

2. The display apparatus of claim 1, wherein the second surface (320b) of the substrate fixing portion (320) directly makes contact with a non-circuit surface (142b) of the printed circuit board (142) on which circuit patterns (148) are not formed.

3. The display apparatus of claim 1, wherein the flexible film (144) comprises a driving chip (146) mounted on a surface facing the first surface (320a) of the substrate fixing portion (320).

4. The display apparatus of claim 3, wherein the substrate fixing portion (320) comprises a first hole (322) in which the driving chip (146) is disposed.

5. The display apparatus of claim 1, wherein the substrate fixing portion (320) comprises a guide recess (324) formed in the second direction (D2) toward the main receiving portion (310) and guiding the flexible film (144) to be bent to cover the substrate fixing portion (320).

6. The display apparatus of claim 1, wherein the substrate fixing portion (320) is connected to one of the sidewalls (312) at a position on the sidewall (312) that is closer to the display panel (PL) than the position where the bottom plate (313) is connected to the sidewall (312).

7. The display apparatus of claim 6, wherein the substrate fixing portion (320) comprises a protrusion (326) formed on a first end portion opposite to a second end portion at which the substrate fixing portion (320) is connected to the main receiving portion (310), and protruding from the first surface (320a) to the second surface (320b) of the substrate fixing portion (320).

8. The display apparatus of claim 1, further comprising a mold frame (500) disposed between the display panel (PL) and the receiving container (300), wherein the mold frame (500) comprises:
a main body portion (510) fixing the light source module (200) to the receiving container (300) and supporting the display panel (PL); and
a cover portion (520) connected to the main body portion (510) and extending along a side portion of the main body portion (510) in the first direction (D1).

9. The display apparatus of claim 8, wherein the main body portion (510) is received in the main receiving portion (310), and
the cover portion (520) is disposed on the substrate fixing portion (320).

10. The display apparatus of claim 9, wherein the cover portion (520) is disposed between the substrate fixing portion (320) and the flexible film (144).

11. The display apparatus of claim 8, wherein the cover portion (520) comprises a second hole (522) formed in an area corresponding to an area in which a first hole (322) of the substrate fixing portion (320) is formed, and a driving chip (146) mounted on the flexible film (144) is disposed in the first hole (322).

12. The display apparatus of claim 11, wherein a first opening (521) is formed at the cover portion (520) between the second holes (522) adjacent to each other.

13. The display apparatus of claim 12, wherein a second opening (321) is formed at the substrate fixing portion (320) between the first holes (322) adjacent to each other.

14. The display apparatus of claim 8, wherein the cover portion (520) comprises a corresponding recess (524) corresponding to a guide recess (324) of the substrate fixing portion (320) formed toward the main receiving portion (310).

15. The display apparatus of claim 1, wherein the light source module (200) is disposed at a short side portion (101) of the display panel (PL), and
the printed circuit board (142) is disposed at a long side portion (102) of the display panel (PL).

16. The display apparatus of claim 15, wherein the long side portion (102) of the display panel (PL) is formed along the first direction (D1), and the short side portion (101) of the display panel (PL) is formed along the second direction (D2).

17. The display apparatus of claim 13, wherein the display panel (PL) comprises:
a first substrate (110) having the flexible film (144) attached at the long side portion (102) and a gate driving chip (146) mounted on the short side portion (101); and
a second substrate (120) opposite to the first substrate (110) and having a liquid crystal layer disposed between the first and second substrates (110, 120).

18. The display apparatus of claim 1, wherein the receiving container (300) further comprises a connecting portion (330) disposed on a side portion connected to the substrate fixing portion (320), disposed adjacent to both ends of the substrate fixing portion (320), and having a hole formed through the connecting portion (330).

## Patentansprüche

1. Display-Vorrichtung, umfassend:
ein Display-Panel (PL), das zum Anzeigen eines Bildes konfiguriert ist;
ein Lichtquellenmodul (200), das dazu konfiguriert ist, das Display-Panel (PL) mit Licht zu versorgen;
eine Leiterplatte (142), die mit dem Lichtquellenmodul (200) und mit dem Display-Panel (PL) über einen flexiblen Film (144) elektrisch verbunden ist; und
einen Aufnahmebehälter (300), der einen Hauptaufnahmeabschnitt (310) und einen Substratbefestigungsabschnitt (320) umfasst, wobei der Hauptaufnahmeabschnitt (310) vier Seitenwände (312) und eine Bodenplatte (313) umfasst, die mit den Seitenwänden (312) verbunden ist, um einen Aufnahmeraum zu begrenzen, der das Lichtquellenmodul (200) und das Display-Panel (PL) aufnimmt, wobei der Substratbefestigungsabschnitt (320) integriert mit dem Hauptaufnahmeabschnitt (310) verbunden ist, sich entlang einer Seitenwand des Hauptaufnahmeabschnitts (310) in eine erste Richtung (D1) erstreckt, vom Hauptaufnahmeabschnitt (310) in eine zweite Richtung (D2) im rechten Winkel zur ersten Richtung (D1) nach außen vorspringt und die Leiterplatte (142) trägt;
wobei sich der flexible Film (144) vom Display-Panel (PL) in die zweite Richtung (D2) über eine erste Oberfläche (320a) des Substratbefestigungsabschnitts (320) auswärts erstreckt und von der ersten Oberfläche (320a) zu einer zweiten Oberfläche (320b) des Substratbefestigungsabschnitts (320) gegenüber der ersten Oberfläche (320a) gebogen ist; und
wobei die Leiterplatte (142) Kontakt mit der zweiten Oberfläche (320b) des Substratbefestigungsabschnitts (320) aufnimmt.

2. Display-Vorrichtung gemäß Anspruch 1, wobei die zweite Oberfläche (320b) des Substratbefestigungsabschnitts (320) direkt Kontakt aufnimmt mit einer Nichtschaltkreisoberfläche (142b) der Leiterplatte (142), auf der keine Schaltkreisstrukturen (148) ausgebildet sind.

3. Display-Vorrichtung gemäß Anspruch 1, wobei der flexible Film (144) einen Steuerchip (146) umfasst, der auf einer Oberfläche montiert ist, die der ersten Oberfläche (320a) des Substratbefestigungsabschnitts (320) zugewandt ist.

4. Display-Vorrichtung gemäß Anspruch 3, wobei der Substratbefestigungsabschnitt (320) ein erstes Loch (322) umfasst, in dem der Steuerchip (146) angeordnet ist.

5. Display-Vorrichtung gemäß Anspruch 1, wobei der Substratbefestigungsabschnitt (320) eine Führungsausnehmung (324) aufweist, die in der zweiten Richtung (D2) zum Hauptaufnahmeabschnitt (310) hin ausgebildet ist und den flexiblen Film (144) führt, um so gebogen zu werden, dass er den Substratbefestigungsabschnitt (320) abdeckt.

6. Display-Vorrichtung gemäß Anspruch 1, wobei der Substratbefestigungsabschnitt (320) mit einer der Seitenwände (312) an einer Position der Seitenwand (312) verbunden ist, die näher am Display-Panel (PL) als an der Position liegt, wo die Bodenplatte (313) mit der Seitenwand (312) verbunden ist.

7. Display-Vorrichtung gemäß Anspruch 6, wobei der Substratbefestigungsabschnitt (320) einen Vorsprung (326) umfasst, der an einem ersten Endabschnitt gegenüber einem zweiten Endabschnitt ausgebildet ist, an dem der Substratbefestigungsabschnitt (320) mit dem Hauptaufnahmeabschnitt (310) verbunden ist, und der von der ersten Oberfläche (320a) zur zweiten Oberfläche (320b) des Substratbefestigungsabschnitts (320) vorragt.

8. Display-Vorrichtung gemäß Anspruch 1, die ferner einen Formrahmen (500) umfasst, der zwischen dem Display-Panel (PL) und dem Aufnahmebehälter (300) angeordnet ist, wobei der Formrahmen (500) umfasst:
einen Hauptkörperabschnitt (510), der das Lichtquellenmodul (200) am Aufnahmebehälter (300) befestigt und das Display-Panel (PL) trägt; und
einen Abdeckungsabschnitt (520), der mit dem Hauptkörperabschnitt (510) verbunden ist und sich entlang eines Seitenabschnittes des Hauptkörperabschnittes (510) in die erste Richtung (D1) erstreckt.

9. Display-Vorrichtung gemäß Anspruch 8, wobei der Hauptkörperabschnitt (510) im Hauptaufnahmeabschnitt (310) aufgenommen ist und der Abdeckungsabschnitt (520) auf dem Substratbefestigungsabschnitt (320) angeordnet ist.

10. Display-Vorrichtung gemäß Anspruch 9, wobei der Abdeckungsabschnitt (520) zwischen dem Substratbefestigungsabschnitt (320) und dem flexiblen Film (144) angeordnet ist.

11. Display-Vorrichtung gemäß Anspruch 8, wobei der Abdeckungsabschnitt (520) ein zweites Loch (522) umfasst, das in einem Bereich ausgebildet ist, der einem Bereich entspricht, in dem ein erstes Loch (322) des Substratbefestigungsabschnitts (320) ausgebildet ist, und wobei ein Steuerchip (146), der auf dem flexiblen Film (144) montiert ist, im ersten Loch (322) angeordnet ist.

12. Display-Vorrichtung gemäß Anspruch 11, wobei eine erste Öffnung (521) am Abdeckungsabschnitt (520) zwischen den aneinander angrenzenden zweiten Löchern (522) ausgebildet ist.

13. Display-Vorrichtung gemäß Anspruch 12, wobei eine zweite Öffnung (321) am Substratbefestigungsabschnitt (320) zwischen den aneinander angrenzenden ersten Löchern (322) ausgebildet ist.

14. Display-Vorrichtung gemäß Anspruch 8, wobei der Abdeckungsabschnitt (520) eine entsprechende Ausnehmung (524) in Entsprechung zu einer Führungsausnehmung (324) des Substratbefestigungsabschnitts (320) umfasst, die zu dem Hauptaufnahmeabschnitt (310) hin ausgebildet ist.

15. Display-Vorrichtung gemäß Anspruch 1, wobei das Lichtquellenmodul (200) an einem kurzen Seitenabschnitt (101) des Display-Panels (PL) angeordnet ist, und
die Leiterplatte (142) an einem langen Seitenabschnitt (102) des Display-Panels (PL) angeordnet ist.

16. Display-Vorrichtung gemäß Anspruch 15, wobei der lange Seitenabschnitt (102) des Display-Panels (PL) entlang der ersten Richtung (D1) und der kurze Seitenabschnitt (101) des Display-Panels (PL) entlang der zweiten Richtung (D2) ausgebildet ist.

17. Display-Vorrichtung gemäß Anspruch 13, wobei das Display-Panel (PL) umfasst:
ein erstes Substrat (110), an dessen langem Seitenabschnitt (102) der flexible Film (144) festgemacht und an dessen kurzem Seitenabschnitt (101) ein Gate-Steuerchip (146) montiert ist; und
ein zweites Substrat (120) gegenüber dem ersten Substrat (110), wobei zwischen dem ersten und dem zweiten Substrat (110, 120) eine Flüssigkristallschicht angeordnet ist.

18. Display-Vorrichtung gemäß Anspruch 1, wobei der Aufnahmebehälter (300) ferner einen Verbindungsabschnitt (330) umfasst, der auf einem Seitenabschnitt angeordnet ist, der mit dem Substratbefestigungsabschnitt (320) verbunden ist, der angrenzend an beiden Enden des Substratbefestigungsabschnitts (320) angeordnet ist, und wobei durch den Verbindungsabschnitt (330) ein Loch gebildet ist.

## Revendications

1. Un appareil d'affichage, comprenant :
Un panneau d'affichage (PL), configuré pour afficher une image ;
Un module de source de lumière (200) configuré pour fournir de la lumière au panneau d'affichage (PL) ;
Une carte de circuit imprimé (142) connectée électriquement au module de source de lumière (200), et connectée électriquement au panneau d'affichage (PL) au travers d'un film flexible (144) ; et
Un container de réception (300) qui comprend une portion de réception principale (310) et une portion de fixation de substrat (320), la portion de réception principale (310) inclut quatre murs latéraux (312) et une plaque inférieure (313) connectée aux murs latéraux (312) pour définir un espace de réception recevant le module de source de lumière (200) et le panneau d'affichage (PL), la portion de fixation du substrat (320) est intégralement connectée à la portion de réception principale (310), s'étend le long d'un mur latéral de la portion de réception principale (310) dans une première direction (D1), est en saillie vers l'extérieur à partir de la portion de réception principale (310) dans une deuxième direction (D2) orthogonale à la première direction (D1), et soutient la carte de circuit imprimé (142) ;
Où le film flexible (144) s'étend vers l'extérieur à partir du panneau d'affichage (PL) dans ladite deuxième direction (D2) sur une première surface (320a) de la portion de fixation de substrat (320), et est plié à partir de la première surface (320a) vers une deuxième surface (320b) de la portion de fixation de substrat (320) à l'opposé de la première surface (320a) ; et
Où la carte de circuit imprimé (142) fait contact avec la deuxième surface (320b) de la portion de fixation de substrat (320).

2. L'appareil d'affichage de la revendication 1, où la deuxième surface (320b) de la portion de fixation de substrat (320) fait directement contact avec une surface sans circuit (142b) de la carte de circuit imprimé (142) sur laquelle des modèles de circuit (148) ne sont pas formés.

3. L'appareil d'affichage de la revendication 1, où le film flexible (144) comprend une puce d'entraînement (146) montée sur une surface faisant face à la première surface (320a) de la portion de fixation de substrat (320).

4. L'appareil d'affichage de la revendication 3, où la portion de fixation de substrat (320) comprend un premier trou (322) dans lequel la puce d'entraînement (146) est disposée.

5. L'appareil d'affichage de la revendication 1, où la portion de fixation de substrat (320) comprend une rainure guide (324) formée dans la deuxième direction (D2) vers la portion de réception principale (310) et guidant le film flexible (144) à plier pour couvrir la portion de fixation de substrat (320).

6. L'appareil d'affichage de la revendication 1, où la portion de fixation de substrat (320) est connectée à l'un des murs latéraux (312) à une position sur le mur latéral (312) qui est plus proche du panneau d'affichage (PL) que la position où la plaque inférieure (313) est connectée au mur latéral (312).

7. L'appareil d'affichage de la revendication 6, où la portion de fixation de substrat (320) comprend une saillie (326) formée sur la première portion finale opposée à une deuxième portion finale à laquelle la portion de fixation de substrat (320) est connectée à la portion de réception principale (310), et en saillie à partir de la première surface (320a) jusqu'à la deuxième surface (320b) de la portion de fixation de substrat (320).

8. L'appareil d'affichage de la revendication 1, comprenant de plus un cadre de moule (500) disposé entre le panneau d'affichage (PL) et le container de réception (300), où le cadre de moule (500) comprend :
Une portion du corps principal (510) fixant le module de source de lumière (200) au container de réception (300) et soutenant le panneau d'affichage (PL) ; et
Une portion de couverture (520) connectée à la portion du corps principal (510) et s'étendant le long d'une portion latérale de la portion du corps principal (510) dans la première direction (D1).

9. L'appareil d'affichage de la revendication 8, où la portion du corps principal (510) est reçue dans la portion de réception principale (310), et
La portion de couverture (520) est disposée sur la portion de fixation de substrat (320).

10. L'appareil d'affichage de la revendication 9, où la portion de couverture (520) est disposée entre la portion de fixation de substrat (320) et le film flexible (144).

11. L'appareil d'affichage de la revendication 8, où la portion de couverture (520) comprend un deuxième trou (522) formé dans une zone correspondant à une zone dans laquelle un premier trou (322) de la portion de fixation de substrat (320) est formé, et une puce d'entraînement (146) montée sur le film flexible (144) est disposée dans le premier trou (322).

12. L'appareil d'affichage de la revendication 11, où une première ouverture (521) est formée au niveau de la portion de couverture (520) entre les deuxièmes trous (522) adjacents l'un à l'autre.

13. L'appareil d'affichage de la revendication 12, où une deuxième ouverture (321) est formée au niveau de la portion de fixation de substrat (320) entre les premiers trous (322) adjacents l'un à l'autre.

14. L'appareil d'affichage de la revendication 8, où la portion de couverture (520) comprend un creux correspondant (524) correspondant à une rainure guide (324) de la portion de fixation de substrat (320) formée vers la portion de réception principale (310).

15. L'appareil d'affichage de la revendication 1, où le module de source de lumière (200) est disposé au niveau d'une portion latérale courte (101) du panneau d'affichage (PL), et
La carte de circuit imprimé (142) est disposée au niveau d'une portion latérale longue (102) du panneau d'affichage (PL).

16. L'appareil d'affichage de la revendication 15, où la portion latérale longue (102) du panneau d'affichage (PL) est formée le long de la première direction (D1) et la portion latérale courte (101) du panneau d'affichage (PL) est formée le long de la deuxième direction (D2).

17. L'appareil d'affichage de la revendication 13, où le panneau d'affichage (PL) comprend :
Un premier substrat (110) ayant le film flexible (144) attaché au niveau de la portion latérale longue (102) et une puce d'entraînement de grille (146) montée sur la portion latérale courte (101) ; et
Un deuxième substrat (120) opposé au premier substrat (110) et ayant une couche de cristaux liquides disposée entre le premier et le deuxième substrats (110, 120).

18. L'appareil d'affichage de la revendication 1, où le container de réception (300) comprend de plus une portion de connexion (330) disposée sur une portion latérale connectée à la portion de fixation de substrat (320), disposée de façon adjacente aux deux extrémités de la portion de fixation de substrat (320) et ayant un trou formé au travers de la portion de connexion (330).
